(19) Europäisches Patentamt
European Patent Office
Office européen des brevets

(11) **EP 1 211 804 B1**

(12) **EUROPEAN PATENT SPECIFICATION**

(45) Date of publication and mention
of the grant of the patent:
**28.03.2007 Bulletin 2007/13**

(51) Int Cl.:
***H03F 3/45*** (2006.01)

(21) Application number: **00126640.2**

(22) Date of filing: **04.12.2000**

(54) **Driver for an external FET with high accuracy and gate voltage protection**

Treiber für einen externen Feldeffekttransistor mit hoher Genauigkeit und Gate-Spannungsschutz

Circuit d'attaque pour un transistor externe à grande fidélité et protection de la tension de grille

(84) Designated Contracting States:
**DE FI FR GB IT SE**

(43) Date of publication of application:
**05.06.2002 Bulletin 2002/23**

(73) Proprietor: **Infineon Technologies AG**
**81669 München (DE)**

(72) Inventors:
• **Bernardon, Derek**
**A-9500 Villach (AT)**
• **Müllauer, Markus**
**A-9800 Spittal (AT)**

(74) Representative: **Graf Lambsdorff, Matthias**
**Patentanwälte**
**Lambsdorff & Lange**
**Dingolfinger Strasse 6**
**81673 München (DE)**

(56) References cited:
**EP-A- 0 492 374** **US-A- 4 626 795**
**US-A- 5 731 686** **US-A- 5 774 021**

• **BARBARA N V ET AL: "IONIZING-RADIATION-INDUCED DEGRADATION IN ELECTRONIC POWER AMPLIFIERS" CONFERENCE RECORD OF THE INDUSTRY APPLICATIONS SOCIETY ANNUAL MEETING,US,NEW YORK, IEEE, vol. MEETING 25, 7 October 1990 (1990-10-07), pages 1667-1672, XP000203614 ISBN: 0-87942-553-9**
• **HORKY R J: "STROMVERSTAERKER MIT MOSFETS. \TEIL 1" FUNKSCHAU,DE,FRANZIS-VERLAG K.G. MUNCHEN, vol. 63, no. 21, 4 October 1991 (1991-10-04), page 118 XP000264612 ISSN: 0016-2841**

## Description

The invention relates to a battery or accumulator charger.

A problem which occurs in technologies where zener diodes are not available, is driving an external FET (field effect transistor). FETs are, for instance, used as current supply units in linear regulators or battery or accumulator chargers as well as in a vast field of other applications.

In most such implementations, it is necessary to protect the gate electrode of the FET from high voltages relative to the source electrode potential. Gate voltage limitation is a necessity when FETs with low threshold voltages are used, like in chargers for wireless applications (i.e. cellular or cordless phones etc.)

Beside the aspect of voltage limitation, it is desired that the current outputted by the FET is controllable with high accuracy. Therefore, the driving voltage for the FET is demanded to show a high degree of insensitivity to variations of the operating voltage, often denoted as line variations.

Further, a very low minimum FET output current should be available.

Conventionally, operational amplifiers (opamps) are used for driving an external FET. In the past, voltage protection has been accomplished by adding an external clamping diode to the output of the opamp or by using an opamp with an output stage provided with an integrated zener diode. These solutions, however, suffer from low accuracy due to the fact that their null point (voltage output at short-circuit input condition) is difficult to control. In order to design a regulator with low minimum output current, an output FET with very small transconductance and a driving opamp with a very high gain are required. The corresponding specifications are difficult to meet.

The article "Stromverstärker mit MOSFETs", R. J. Horky, Funkschau, DE, Franzis-Verlag K.G., München, Vol. 63, No. 21, describes a driver circuit to be used as an audio line driver or an audio amplifier for headphones.

US 5,731,686 relates to a battery overtemperature protection circuit which is used in a battery charger device.

US 5,774,021 relates to an operational transconductance amplifier containing a differential pair of transistors. The operational transconductance amplifier may be used in battery charges.

It is therefore an object of the invention, to provide for an improved battery or accumulator charger equipped with a circuit for driving an external FET which is insensitive to line variations. In particular, the invention shall enable the implementation of a battery or accumulator charger with high accuracy and low minimum output current. More particularly, the battery or accumulator charger shall provide for an effective voltage limitation at the gate-source electrodes of the external FET.

The object of the invention is solved by the battery or accumulator charger according to the features of claim 1.

Thus, the battery or accumulator charger of the invention includes a differential amplification stage, and a load resistor included in a current flow path, the current flowing through the current flow path being controlled by the voltage between two input terminals of the differential amplification stage and being substantially independent of variations of either of the first or second operating potential. As the load resistor being connected between the gate and source electrodes of the FET, line variations do not result in voltage variations across the gate and source electrodes of the FET.

Preferably, the resistance value of the load resistor is chosen to provide a voltage across the gate and source electrodes of the FET near or substantially equal to the threshold voltage of the FET in case the potentials applied to the two input terminals of the differential amplification stage are set to the same value. Then, the null point of the circuit is set to match with the optimal low current operating condition of the FET. This increases the accuracy of the battery or accumulator charger at very low source-drain currents of the FET.

According to a specifically advantageous aspect of the invention, the differential amplification stage comprises a first and a second current flow path, both thereof are biased by a common constant current source, the first and second current flow paths are provided with a differential transistor pair the control electrodes thereof are connected to the first and second input terminals, respectively, and the current flow path of the output load resistor being either the first or the second current flow path of the differential amplification stage. In this embodiment, the load resistor is simply located in one of the flow paths of the differential amplification stage. Thus, the common constant current source feeding the differential amplification stage simultaneously supplies the current flowing through the load resistor. As the maximum current flowing through one of the first or second current flow paths of the differential amplification stage is limited by the current outputted by the common constant current source, a built-in limitation of the voltage across the load resistor is achieved.

Further preferred features and advantages of the invention are described in the dependent claims.

The invention is illustrated in the accompanying drawings, in which:

Fig. 1    is a schematic electrical diagram of a circuit in accordance with a preferred embodiment of the invention;

Fig. 2    is a simplified block diagram for explanation of the null point of an opamp;

Fig. 3    is a pictorial representation of the output voltage of the circuit of Fig. 1 and of a conventional opamp versus the differential input voltage thereof; and

Fig. 4 is a schematic block diagram of a negative feedback control network applied to an amplification circuit with a null point different from zero.

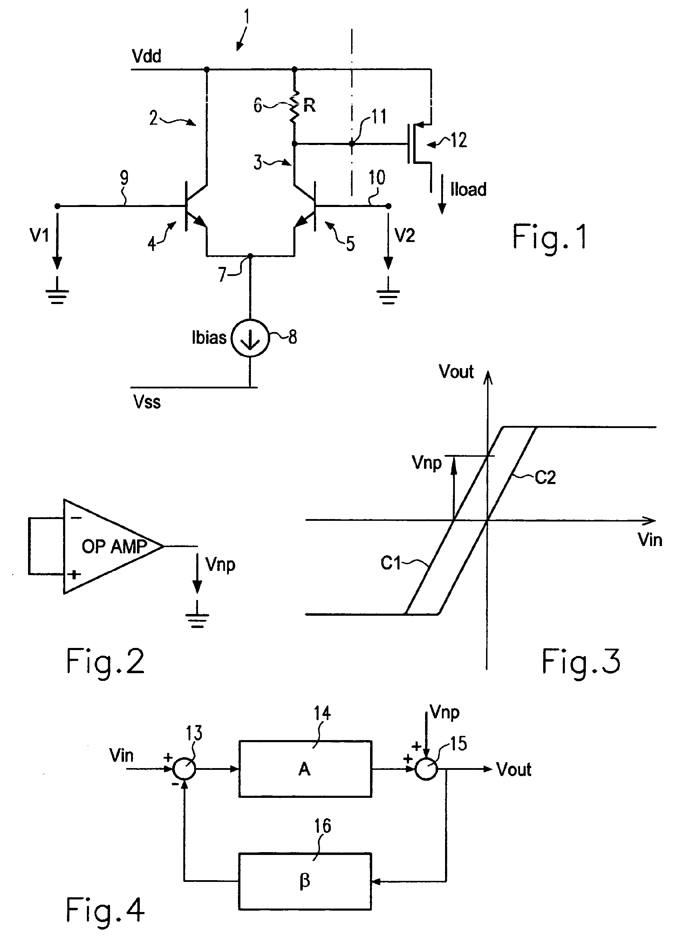

A schematic of an embodiment of the circuit for driving an external FET is shown in Fig. 1. The driving circuit 1 has two current flow paths 2 and 3. The current flow path 2 includes a first bipolar npn transistor 4 and the second current flow path 3 includes a second npn tranistor 5 connected in series with a load resistor 6. The emitters of the first and second transistors 4, 5 are connected to a common node 7.

A constant current source 8 is connected between an operating potential Vss and the common node 7 to source a current Ibias to the two current flow paths 2 and 3. On the other hand, the collector of the first transistor 4 and a first terminal of the load resistor 6 are connected to another operating potential Vdd. The second terminal of the load resistor 6 opposite to the first resistor terminal is connected to the collector of the second transistor 5.

The constant current source 8, transistor pair 4 and 5, and the load resistor 6 may be implemented in an integrated circuit (IC) which is driven by the operating voltage Vdd-Vss.

Input terminals of the driving circuit 1 are represented by lines 9 and 10 connected to the bases of the transistors 4 and 5, respectively.

An output terminal of the driving circuit 1 is denoted by reference sign 11. The output terminal 11 is connected with the second current flow path 3 at a point thereof between the collector of the second transistor 5 and the load resistor 6.

The external FET to be controlled by the driving circuit 1 is denoted by reference sign 12. In the arrangement shown in Fig. 1, the FET 12 is a PMOS FET. The source of the FET 12 is connected to Vdd whereas the gate of the FET 12 is connected to the output terminal 11. The dash-dotted line represents the boundary of the IC comprising the driving circuit 1.

Driving circuit 1 and FET 12 establish a linear regulator, the output thereof is represented by the drain of the FET 12. This linear regulator, for instance, may be a battery or accumulator charger. In this case, the battery or accumulator to be charged is fed by the drain current Iload of the FET 12.

It is to be noted that the driving circuit 1, as concerns the differential input transistor pair 4, 5 and the common current source 8, is similar to a conventional opamp. However, a conventional opamp uses, as an input stage, a symmetric differential amplifier whereas the two current flow paths 2, 3 are asymmetric due to the load resistor 6. Further, an opamp is equipped with a transistor output amplification stage whereas the output stage of the circuit according to Fig. 1 is represented by the load resistor 6, which is preferably realized by a low ohmic polysilicon resistor.

In operation, the constant current source 8, which is controled by a bandgap voltage (not shown), biases the two transistors 4, 5 by the total current Ibias. Like the bandgap voltage, the current Ibias is independent of temperature and parametric variations.

First, considering the voltage limitation aspect of the driving circuit 1, the maximum voltage drop that can occur across the load resistor 6 is R*Ibias, where R denotes the resistance of the load resistor. Thus, irrespective of the input voltages at lines 9 and 10, the maximum voltage between gate and source of the FET 12 is limited to this specific value. Therefore, in the event of an over voltage appearing at the source of the FET 12 (for instance due to a sudden increase in Vdd), the potential at the gate of the FET 12 is automatically pulled up. This protects the FET 12 from being damaged, provided that R*Ibias has a sufficient small value, for instance 1,5 to 2,0 volts.

A further advantage of the driving circuit 1 is that it is insensitive to line variations, i.e. variations of the operating potentials Vdd or Vss. When a variation of Vdd or Vss occurs, the current flows through both branches 2 and 3 of the input amplification stage remain constant, because the currents depend only on the voltage difference $\Delta V = V1-V2$ between the voltages V1 and V2 inputted into the input amplification stage at lines 9 and 10, respectively. This implies that the voltage across the load resistor 6 remains constant without requiring a variation of input voltages V1 or V2 for balancing line variations. In fact, no systematic error occurs due to line variations, thus maintaining the external PMOS FET 12 always properly biased.

Still further, the driving circuit 1 fulfills the high accuracy requirements imposed on regulators for the generation of very low source-drain currents.

For explanation, assume that the two input terminals 9 and 10 are interconnected. In this case, the driving circuit 1 will have a DC output voltage Vnp at 11 relative to ground. Vnp is denoted by the expression null point. It is noted, that the existence of a null point unequal to zero is a fundamental characteristic of the driving circuit 1 and even exists with ideal transistors 4 and 5. In case of ideal transistors 4 and 5, the null point amounts to Vnp=Vdd-R*Ibias/2.

Fig. 2 is a simplified block diagram for explanation of the null point of an opamp. Analogously, the null point of an opamp is the output voltage with respect to ground in case that the differential input terminals are connected. As the ground is usually given by the mean of the operating potentials (this is also the case for an asymmetric or even unipolar operating voltage), the null point is the offset of the opamp. The offset of an opamp is usually adjusted to zero in order to provide for full differential amplification of the input differential voltage.

Fig. 3 is a pictorial representation of the output voltage Vout of the circuit of Fig. 1 at terminal 11 (curve C1) and of an exemplary opamp (curve C2) versus the differential input voltage Vin=V1-V2. The output voltage Vout is drawn on the y-axis and the differential input voltage Vin is drawn on the x-axis. As apparent from fig. 3, curve C1 intersects the y-axis at Vnp different to zero, whereas the curve C2 intersects the y-axis at zero output voltage. The slopes of the curves C1 and C2 are given by the open circuit voltage gains of the respective circuits, which, in this example, are chosen to be equal.

Now, let us assume that the opamp with zero null point voltage is used in a closed loop system with a negative feedback network. Then, according to basic control theory, the output voltage of the opamp is given by the expression

$$Vout \;=\; Vin/(1+A*\beta)$$

where A denotes the open circuit voltage gain and $\beta$ denotes the feedback factor of the feedback network. Basic control theory always assumes that the null point is set to zero. Therefore, in order to achieve a certain output voltage different from zero, a certain amount of voltage between the input terminals of the opamp is required, and this voltage difference is reflected to the output voltage as a systematic error.

Fig. 4 is a schematic block diagram of a negative feedback amplifier control network for the case of a null point output voltage Vnp which is or may be unequal to zero. A realization of this system is, for example, circuit 1 provided with a negative feedback network between output 11 and input terminal 10.

The input of this circuit is realized by a non-inverting input of a substracter 13. The amplification stage 14 provides for an open circuit voltage gain A (corresponding to the amplification of circuit 1). The output of the amplification stage 14 is connected to an input of an adder 15. The other input of the adder 15 receives the null point voltage Vnp. The adder 15 output, multiplied by the feedback factor $\beta$ of the feedback network 16, is negatively fed back to the amplification stage 14 via the inverting input of the substracter 15. Thus, the system shown in Fig. 4 is a negative feedback amplifier with variable null point.

The output voltage of this negative feedback system becomes

$$Vout \;=\; (Vnp+A*Vin)/(1+A*\beta)$$

For large values of A, Vout$\approx$Vin/$\beta$. This is equivalent to the usual case when using an opamp as amplification stage 14 with zero null point voltage Vnp.

The steady state error at the output of this system is given by the equation

$$Ess=(Vin-\beta*Vnp)/(\beta+\beta^2*A)$$

According to the above equation, in case of Vnp=Vin/$\beta$, the steady state error Ess becomes zero independent of the open circuit gain A.

On the other hand, as already mentioned, Vin/$\beta\approx$Vout for large values of A. Therefore, by setting the null point Vnp near to the desired output voltage, the voltage Vin required becomes very small, thereby causing a very small systematic error at the output.

Therefore, the null point of the circuit 1, namely Vnp = Vdd-R*(Ibias/2), is set near to the threshold voltage of the external PMOS FET 12. This can be achieved by choosing appropriate values for R and/or Ibias. Then, the PMOS FET 12 is driven near its threshold value, and the transconductance of the PMOS FET 12 is very low for low output currents of the FET, where most accuracy is needed.

**Claims**

1. A battery or accumulator charger, comprising:

   - a differential amplification stage (4, 5, 8) with two input terminals (9, 10), the differential amplification stage (4, 5, 8) being supplied by an operating voltage defined by a first and second operating potential (Vss, Vdd),
   - an output load resistor (6) included in a current flow path (3), the current flowing through the current flow path (3) being controlled by the voltage (V1-V2) between the two input terminals (9, 10) of the differential amplification stage (4, 5, 8) and being substantially independent of variations of either the first or second operating potential (Vss, Vdd), and
   - an external FET, wherein
   - the output load resistor (6) being connected between the gate and source electrodes of the external FET (12) to be driven.

2. The battery or accumulator charger according to claim 1,
   **characterized in that**

   - the resistance value (R) of the output load resistor (6) is chosen to provide a voltage across the gate and source electrodes of the FET (12) near to or substantially equal the threshold voltage of the FET (12) in case the potentials (V1, V2) applied to the two input terminals of the differential amplification stage are set to the same value.

3. The battery or accumulator charger according to claims 1 or 2,
**characterized in that**

- the differential amplification stage (4, 5, 8) comprising a first and a second current flow path (2, 3), both thereof are biased by a common constant current source (8),
- the first and second current flow paths (2, 3) are provided with a differential transistor pair (4, 5) the control electrodes thereof are connected to the first and second input terminals (9, 10), respectively, and
- the current flow path (3) including the output load resistor (6) being either the first or the second current flow path (2, 3) of the differential amplification stage (4, 5, 8).

4. The battery or accumulator charger according to one or more of the preceding claims,
**characterized in that**

- the FET (12) to be driven is a PMOS FET.

5. The battery or accumulator charger according to claims 3 or 4,
**characterized in that**

- the transistors (4, 5) of the transistor pair are bipolar transistors.

6. The battery or accumulator charger according to one or more of the preceding claims,
**characterized in that**

- a first terminal of the output load resistor (6) is connected to a first operating potential (Vdd).

7. The battery or accumulator charger of one or more of claims 3 to 6,
**characterized in that**

- a second terminal of the output load resistor (6) is connected to a collector electrode of the transistor (5) arranged within the current flow path (3) including the output load resistor (6).

8. The battery or accumulator charger according to claim 7,
**characterized in that**

- the source electrode of the FET (12) is connected to the first operating potential (Vdd), and
- the gate electrode of the FET is connected to the second terminal of the output load resistor (6).

9. The battery or accumulator charger according to claims 3 to 8,

**characterized in that**

- the emitter electrodes of the two transistors (4, 5) being connected to a first common terminal of the constant current source (8), and
- a second terminal of the constant current source is connected to the second operating potential (Vss).

**Patentansprüche**

1. Ein Batterie- oder Akkumulator-Ladegerät umfassend:

- eine Differenzverstärkerstufe (4, 5, 8) mit zwei Eingangsanschlüssen (9, 10), wobei die Differenzverstärkerstufe (4, 5, 8) durch eine Betriebsspannung versorgt wird, welche durch ein erstes und zweites Betriebspotential (Vss, Vdd) definiert ist,
- ein Ausgangslastwiderstand (6), enthalten in einem Stromflusspfad (3), wobei der durch den Stromflusspfad (3) fließende Strom durch die Spannung (V1-V2) zwischen den zwei Eingangsanschlüssen (9, 10) der Differenzverstärkerstufe (4, 5, 8) gesteuert wird und im Wesentlichen unabhängig von Änderungen entweder des ersten oder zweiten Betriebspotentials (Vss, Vdd) ist, und
- ein externer FET, wobei
- der Ausgangslastwiderstand (6) zwischen den Gate- und Source-Elektroden des externen, zu treibenden FET (12) verbunden ist.

2. Das Batterie- oder Akkumulator-Ladegerät gemäß Anspruch 1,
**dadurch gekennzeichnet, dass**

- der Widerstandswert (R) des Ausgangslastwiderstandes (6) gewählt wird, um eine Spannung über die Gate- und Source-Elektroden des FET (12) bereitzustellen, welche nahezu oder im Wesentlichen gleich der Schwellwertspannung des FET (12) ist, falls die an die zwei Eingangsanschlüsse der Differenzverstärkerstufe angelegten Potentiale (V1, V2) auf den gleichen Wert eingestellt sind.

3. Das Batterie- oder Akkumulator-Ladegerät gemäß den Ansprüchen 1 oder 2,
**dadurch gekennzeichnet, dass**

- die Differenzverstärkerstufe (4, 5, 8) einen ersten und einen zweiten Stromflusspfad (2, 3) umfasst, wobei beide davon durch eine gemeinsame Konstantstromquelle (8) vorgespannt sind,

- der erste und zweite Stromflusspfad (2, 3) mit einem Differenz-Transistorpaar (4, 5) versehen sind, wobei die Steuerelektroden hiervon jeweils mit den ersten und zweiten Eingangsanschlüssen (9, 10) verbunden sind, und

- der den Ausgangslastwiderstand (6) enthaltende Stromflusspfad (3) entweder der erste oder der zweite Stromflusspfad (2, 3) der Differenzverstärkerstufe (4, 5, 8) ist.

4. Das Batterie- oder Akkumulator-Ladegerät gemäß einem oder mehreren der vorhergehenden Ansprüche,
**dadurch gekennzeichnet, dass**

- der zu treibende FET (12) ein PMOS FET ist.

5. Das Batterie- oder Akkumulator-Ladegerät gemäß den Ansprüchen 3 oder 4,
**dadurch gekennzeichnet, dass**

- die Transistoren (4, 5) des Transistorpaares bipolare Transistoren sind.

6. Das Batterie- oder Akkumulator-Ladegerät gemäß einem oder mehreren der vorhergehenden Ansprüche,
**dadurch gekennzeichnet, dass**

- ein erster Anschluss des Ausgangslastwiderstandes (6) mit einem ersten Betriebspotential (Vdd) verbunden ist.

7. Das Batterie- oder Akkumulator-Ladegerät gemäß einem oder mehreren der Ansprüche 3 bis 6,
**dadurch gekennzeichnet, dass**

- ein zweiter Anschluss des Ausgangslastwiderstandes (6) mit einer Kollektorelektrode des Transistors (5) verbunden ist, welcher in dem den Ausgangslastwiderstand (6) enthaltenden Stromflusspfad (3) angeordnet ist.

8. Das Batterie- oder Akkumulator-Ladegerät gemäß Anspruch 7,
**dadurch gekennzeichnet, dass**

- die Source-Elektrode des FET (12) mit dem ersten Betriebspotential (Vdd) verbunden ist, und
- die Gate-Elektrode des FET mit dem zweiten Anschluss des Ausgangslastwiderstandes (6) verbunden ist.

9. Das Batterie- oder Akkumulator-Ladegerät gemäß den Ansprüchen 3 bis 8,
**dadurch gekennzeichnet, dass**

- die Emitter-Elektroden der zwei Transistoren (4, 5) mit einem ersten gemeinsamen Anschluss der Konstantstromquelle (8) verbunden sind, und
- ein zweiter Anschluss der Konstantstromquelle mit dem zweiten Betriebspotential (Vss) verbunden ist.

## Revendications

1. Chargeur de batterie ou d'accumulateur comprenant :

- un étage (4, 5, 8) différentiel d'amplification ayant deux bornes (9, 10) d'entrée, l'étage (4, 5, 8) différentiel d'amplification étant alimenté en une tension de fonctionnement définie par un premier et un deuxième potentiels (Vss, Vdd) de fonctionnement ;
- une résistance (6) de charge de sortie incluse dans un trajet (3) de courant, le courant passant dans le trajet (3) de courant étant réglé par la tension (Vl-V2) entre les deux bornes (9, 10) d'entrée de l'étage (4, 5, 8) différentiel d'amplification et étant sensiblement indépendant de variation de l'un ou l'autre des premier et deuxième potentiels (Vss, Vdd) de fonctionnement ; et
- un FET extérieur dans lequel
- la résistance (6) de charge de sortie est connectée entre les électrodes de grille et de source du FET (12) extérieur à attaquer.

2. Chargeur de batterie ou d'accumulateur suivant la revendication 1,
**caractérisé en ce que**
la valeur (R) de la résistance (6) de charge de sortie est choisie de manière à procurer une tension aux bornes des électrodes de grille et de source du FET (12) proche de la tension de seuil du FET (12) ou sensiblement égale à celle-ci dans le cas où les potentiels (V1, V2) appliqués aux deux bornes d'entrée de l'étage (4, 5, 8) différentiel d'amplification sont fixés à la même valeur.

3. Chargeur de batterie ou d'accumulateur suivant la revendication 1 ou 2,
**caractérisé en ce que**

- l'étage (4, 5, 8) différentiel d'amplification comprend un premier et deuxième trajets (2, 3) de courant, tous deux polarisés par une source (8) de courant constant ;
- le premier et le deuxième trajets (2, 3) de courant sont munis d'une paire (4, 5) de transistors différentiels dont les électrodes de commande sont reliées aux première et deuxième bornes (9, 10) d'entrée, respectivement ; et

- le trajet (3) de courant comprenant la résistance (6) de charge de sortie est soit le premier soit le deuxième trajet (2, 3) de courant de l'étage (4, 5, 8) différentiel d'amplification.

4. Chargeur de batterie ou d'accumulateur suivant l'une ou plusieurs des revendications précédentes, **caractérisé en ce que**

   - le FET (12) à attaquer est un FET PMOS.

5. Chargeur de batterie ou d'accumulateur suivant la revendication 3 ou 4, **caractérisé en ce que**

   - les transistors (4, 5) de la paire de transistors sont des transistors bipolaires.

6. Chargeur de batterie ou d'accumulateur suivant l'une ou plusieurs des revendications précédentes, **caractérisé en ce que**

   - une première borne de la résistance (6) de charge de sortie est reliée à un premier potentiel (Vdd) de fonctionnement.

7. Chargeur de batterie ou d'accumulateur suivant l'une ou plusieurs des revendications 3 à 6, **caractérisé en ce que**

   - une deuxième borne de la résistance (6) de charge de sortie est reliée à une électrode de collecteur du transistor (5) montée dans le trajet (3) de courant comprenant la résistance (6) de charge de sortie.

8. Chargeur de batterie ou d'accumulateur suivant la revendication 7, **caractérisé en ce que**

   - l'électrode de source du FET (12) est reliée au premier potentiel (Vdd) de fonctionnement ; et
   - l'électrode de grille du FET est reliée à la deuxième borne de la résistance (6) de charge de sortie.

9. Chargeur de batterie ou d'accumulateur suivant les revendications 3 à 8, **caractérisé en ce que**

   - les électrodes d'émetteur des deux transistors (4, 5) sont reliées à une première borne commune de la source (8) de courant constant ; et
   - une deuxième borne de la source de courant constant est reliée au deuxième potentiel (Vss) de fonctionnement.

Vdd

1

2

6  R

3

11

12

9

V1

4

5

10

V2

Iload

7

Ibias  8

Vss

**Fig.1**

OP AMP

Vnp

**Fig.2**

Vout

Vnp

C2

C1

Vin

**Fig.3**

13

14

Vnp

15

Vin

A

Vout

16

β

**Fig.4**